# EUROPEAN PATENT APPLICATION

(11) **EP 4 513 493 A1**
(43) Date of publication of application: **26.02.2025**
(21) Application number: 23806682.3
(22) Date of filing: 20.04.2023
(51) Int. Cl.: G11C 11/22

(54) **FERROELECTRIC MEMORY AND CONTROL APPARATUS THEREFOR, METHOD FOR IMPROVING DURABILITY OF FERROELECTRIC MEMORY, AND DEVICE**

(30) Priority: 18.05.2022 CN 202210539929
(71) Applicant: Huawei Technologies Co., Ltd., Shenzhen, Guangdong 518129 (CN)
(72) Inventor: TAN, Wanliang, Shenzhen, Guangdong 518129 (CN); CAI, Jialin, Shenzhen, Guangdong 518129 (CN); XU, Jeffrey Junhao, Shenzhen, Guangdong 518129 (CN)
(74) Representative: Gill Jennings & Every LLP
(86) International application number: PCT/CN2023/089582
(87) International publication number: WO 2023/221729

(57) **Abstract**

Disclosed are a ferroelectric memory, a control apparatus thereof, a method for increasing endurance of the ferroelectric memory, and a device. The control apparatus of the ferroelectric memory includes a signal control unit (90). The signal control unit (90) is coupled to a memory controller (20), an alternating current signal generator (80), and a plate line coupled to a ferroelectric memory cell. The plate line is connected to one end of a ferroelectric capacitor in the ferroelectric memory cell. The signal control unit (90) is configured to switch a signal input to the plate line to a first alternating current signal generated by the alternating current signal generator (80) or a read/write pulse signal output by the memory controller (20), to repair the ferroelectric capacitor via the first alternating current signal when reading/writing is not required. Alternatively, the signal control unit (90) is configured to superimpose a second alternating current signal generated by the alternating current signal generator (80) and the read/write pulse signal, and input a superimposed signal to the plate line, to assist in reading or writing data via the second alternating current signal. This reduces an operating voltage required for ferroelectric switching, reduces damage caused by an electric field to the ferroelectric capacitor, and increases endurance of the device.

## Description

This application claims priority to Chinese Patent Application No. 202210539929.6, filed with the China National Intellectual Property Administration on May 18, 2022 and entitled "FERROELECTRIC MEMORY, CONTROL APPARATUS THEREOF, METHOD FOR INCREASING ENDURANCE OF FERROELECTRIC MEMORY, AND DEVICE", which is incorporated herein by reference in its entirety.

### TECHNICAL FIELD

This application relates to the field of memory technologies, and in particular, to a ferroelectric memory, a control apparatus thereof, a method for increasing endurance of the ferroelectric memory, and a device.

### BACKGROUND

A ferroelectric memory device has advantages such as a low read/write voltage, low power consumption, a small device size, a high read/write speed, good cycle performance, radiation resistance, and non-volatility, and is expected to be used to build a next-generation memory chip. Compared with a thickness of a conventional ferroelectric material, a thickness of a core multi-layer thin film structure of a hafnium oxide-based ferroelectric device may be reduced to 10 nanometers or even sub-10 nanometers, which can implement high-density integration or even three-dimensional integration. The hafnium oxide-based ferroelectric device has a unique advantage in constructing an ultrahigh-density memory chip. In addition, a preparation process of the hafnium oxide-based ferroelectric device is well compatible with a mature silicon-based semiconductor process. Therefore, the hafnium oxide-based ferroelectric device is expected to become a core unit of a future new ferroelectric memory.

At present, one of biggest problems that restrict application of the hafnium oxide-based ferroelectric device to a commercial memory is endurance (endurance) of the hafnium oxide-based ferroelectric device, that is, the device needs to still maintain good ferroelectric performance after a sufficient quantity of read/write times. Endurance of the hafnium oxide-based ferroelectric device reported at present can only reach an order of magnitude 10¹² at most. If the hafnium oxide-based ferroelectric device is expected to be used in the commercial memory, endurance of the hafnium oxide-based ferroelectric device needs to reach an order of magnitude 10¹⁵ at least. Therefore, how to increase endurance of the hafnium oxide-based ferroelectric device is one of problems that need to be urgently resolved currently.

### SUMMARY

Embodiments of this application provide a ferroelectric memory, a control apparatus thereof, a method for increasing endurance of the ferroelectric memory, and a device. A ferroelectric memory cell is repaired via an alternating current signal, or reading/writing is assisted via the alternating current signal, to reduce damage caused by reading/writing to the ferroelectric memory cell, and increase endurance of the ferroelectric memory.

According to a first aspect, an embodiment of this application provides a control apparatus of a ferroelectric memory, including a signal control unit. The signal control unit is coupled to a memory controller, an alternating current signal generator, and a plate line coupled to a ferroelectric memory cell. The memory controller is configured to implement read/write control on the ferroelectric memory cell. The alternating current signal generator is configured to generate a first alternating current signal. The ferroelectric memory cell includes a ferroelectric capacitor, and the plate line is connected to one end of the ferroelectric capacitor.

The signal control unit is configured to switch a signal input to the plate line to the first alternating current signal or a read/write pulse signal output by the memory controller. The read/write pulse signal is used to write data into the ferroelectric memory cell or read data from the ferroelectric memory cell.

The foregoing control apparatus of the ferroelectric memory may input the alternating current signal to the plate line in a read/write interval of the ferroelectric memory cell, to apply alternating current signals with constantly changing polarities to upper and lower electrodes of the ferroelectric capacitor, so as to drive defects, oxygen vacancies, and the like in a ferroelectric thin film to move away from balanced positions under driving of an alternating electric field to finally implement redistribution. This recovers ferroelectric performance of the ferroelectric thin film to a good level.

In addition, a high frequency makes the electric field apply for a short time, so that defect generation caused by an electric field stress can be effectively avoided.

In addition, for unrecoverable defect generation that occurs in repeated read/write processes, a frequency (1 GHz to 10 GHz) of an alternating current signal is increased, so that dipole molecules in a ferroelectric thin film are reciprocated at a high frequency, and internal friction heat is generated. Therefore, the ferroelectric thin film is heated, a thermal annealing function is achieved, damage in the ferroelectric thin film is repaired, and ferroelectric performance of the ferroelectric thin film is recovered to a good level. In conclusion, the frequency and an amplitude of the alternating current signal are controlled, so that thermal annealing effect and oxygen vacancy redistribution effect of the alternating current signal on the ferroelectric capacitor may be separately controlled. This can effectively alleviate performance deterioration of a ferroelectric device and increase endurance of the device.

In a possible implementation, the control apparatus further includes the memory controller, the memory controller is further configured to send a first enable signal to the signal control unit in a read/write interval of the ferroelectric memory cell, and the first enable signal is used to control the signal control unit to input the first alternating current signal to the plate line.

In a possible implementation, the memory controller is further configured to send a second enable signal to the signal control unit in a read/write process of the ferroelectric memory cell, and the second enable signal is used to control the signal control unit to input the read/write pulse signal to the plate line.

In a possible implementation, the signal control unit includes a first switching transistor and a second switching transistor that are connected in series. A first end of the first switching transistor is coupled to the alternating current signal generator, and is configured to receive the first alternating current signal. A second end of the first switching transistor is coupled to a first end of the second switching transistor. A second end of the second switching transistor is coupled to the memory controller, and is configured to receive the read/write pulse signal. The first enable signal is used to control the first switching transistor to be turned on and the second switching transistor to be turned off. The second enable signal is used to control the first switching transistor to be turned off and the second switching transistor to be turned on.

The signal control unit has a simple structure, so that costs of the apparatus and an occupied volume of the apparatus can be reduced.

In a possible implementation, the first switching transistor is a P-type transistor, and the second switching transistor is an N-type transistor. Alternatively, the first switching transistor is an N-type transistor, and the second switching transistor is a P-type transistor.

In a possible implementation, the first enable signal includes a first signal and a second signal. In the read/write interval of the ferroelectric memory cell, the ferroelectric memory is further configured to send the first signal to the first switching transistor and send the second signal to the second switching transistor. The first signal is used to turn on the first switching transistor. The second signal is used to turn off the second switching transistor.

In a possible implementation, the second enable signal includes a third signal and a fourth signal. In the read/write process of the ferroelectric memory cell, the ferroelectric memory is further configured to send the third signal to the first switching transistor and send the fourth signal to the second switching transistor. The third signal is used to turn off the first switching transistor. The fourth signal is used to turn on the second switching transistor.

In a possible implementation, the alternating current signal generator is configured to generate a second alternating current signal. The signal control unit is further configured to superimpose the second alternating current signal and the read/write pulse signal, and input a superimposed signal to the plate line.

The foregoing control apparatus may implement that, in the read/write process, polarization of the ferroelectric thin film is disturbed via the second alternating current signal, to assist in polarization switching of the ferroelectric thin film, so that an operating voltage required for ferroelectric switching of the ferroelectric thin film can be reduced, and damage caused by an electric field to the ferroelectric thin film is reduced, thereby further improving endurance of the ferroelectric device.

In a possible implementation, the memory controller is further configured to send a third enable signal to the signal control unit in a read/write process of the ferroelectric memory cell, and the third enable signal is used to control the signal control unit to input the superimposed signal to the plate line.

An amplitude of the second alternating current signal is less than 1/2 of an amplitude of the read/write pulse signal, and a frequency of the second alternating current signal is greater than a frequency of the read/write pulse signal.

Optionally, the signal control unit further includes a third switching transistor and a multiplier. A first end of the third switching transistor is coupled to the alternating current signal generator, and is configured to receive the second alternating current signal. A second end of the third switching transistor is coupled to a first input end of the multiplier. A second input end of the multiplier is coupled to the memory controller, and is configured to receive the read/write pulse signal. An output end of the multiplier is coupled to the plate line. The first enable signal is used to control, in the read/write process of the ferroelectric memory cell, the third switching transistor to be turned on.

The signal control unit has a simple structure, so that costs of the apparatus and an occupied volume of the apparatus can be reduced.

According to a second aspect, an embodiment of this application further provides a control apparatus of a ferroelectric memory, including a signal control unit. The signal control unit is coupled to a memory controller, an alternating current signal generator, and a plate line coupled to a ferroelectric memory cell. The memory controller is configured to implement read/write control on the ferroelectric memory cell. The alternating current signal generator is configured to generate an alternating current signal. The ferroelectric memory cell includes a ferroelectric capacitor, and the plate line is connected to one end of the ferroelectric capacitor.

The signal control unit is configured to superimpose the alternating current signal and a read/write pulse signal output by the memory controller, and input a superimposed signal to the plate line. The read/write pulse signal is used to write data into the ferroelectric memory cell or read data from the ferroelectric memory cell.

The foregoing control apparatus may implement that, in a read/write process, polarization of a ferroelectric thin film is disturbed via the alternating current signal, to assist in polarization switching of the ferroelectric thin film, so that an operating voltage required for ferroelectric switching of the ferroelectric thin film can be reduced, damage caused by an electric field to the ferroelectric thin film is reduced, thereby further improving endurance of a ferroelectric device.

In a possible implementation, the control apparatus further includes the memory controller, the memory controller is configured to send a first enable signal to the signal control unit in a read/write process of the ferroelectric memory cell, and the first enable signal is used to control the signal control unit to input superimposition of the alternating current signal and the read/write pulse signal to the plate line.

In a possible implementation, an amplitude of the alternating current signal is less than an amplitude of the read/write pulse signal, and a frequency of the alternating current signal is greater than a frequency of the read/write pulse signal.

In a possible implementation, the signal control unit includes a switching transistor and a multiplier. A first end of the switching transistor is coupled to the alternating current signal generator, and is configured to receive the alternating current signal. A second end of the switching transistor is coupled to a first input end of the multiplier. A second input end of the multiplier is coupled to the memory controller, and is configured to receive the read/write pulse signal. An output end of the multiplier is coupled to the plate line. The first enable signal is used to control, in the read/write process of the ferroelectric memory cell, the switching transistor to be turned on.

According to a third aspect, an embodiment of this application further provides a ferroelectric memory, including a memory array, a signal control unit, and a memory controller. The memory array includes a plurality of ferroelectric memory cells, and all ferroelectric memory cells in one memory array are coupled to a same plate line. The signal control unit is coupled to the memory controller, an alternating current signal generator, and a plate line coupled to the memory array. The memory controller is configured to implement read/write control on each ferroelectric memory cell. The alternating current signal generator is configured to generate a first alternating current signal. Each ferroelectric memory cell includes a ferroelectric capacitor, and the plate line is connected to one end of each ferroelectric capacitor.

The signal control unit is configured to switch a signal input to the plate line to the first alternating current signal or a read/write pulse signal output by the memory controller. The read/write pulse signal is used to write data into the ferroelectric memory cell or read data from the ferroelectric memory cell.

The ferroelectric memory can repair the ferroelectric capacitor in a read/write interval of the ferroelectric memory cell, so that endurance of a device can be increased.

Optionally, the signal control unit and the memory controller may be the signal control unit and the memory controller according to any implementation of the first aspect. Details are not described herein again.

According to a fourth aspect, an embodiment of this application further provides a ferroelectric memory, including a memory array, a signal control unit, and a memory controller. The memory array includes a plurality of ferroelectric memory cells, and all ferroelectric memory cells in one memory array are coupled to a same plate line. The signal control unit is coupled to the memory controller, an alternating current signal generator, and a plate line coupled to the memory array. The memory controller is configured to implement read/write control on each ferroelectric memory cell. The alternating current signal generator is configured to generate an alternating current signal. Each ferroelectric memory cell includes a ferroelectric capacitor, and the plate line is connected to one end of each ferroelectric capacitor.

The signal control unit is configured to superimpose the alternating current signal and a read/write pulse signal output by the memory controller, and input a superimposed signal to the plate line. The read/write pulse signal is used to write data into the ferroelectric memory cell or read data from the ferroelectric memory cell.

The foregoing ferroelectric memory may implement that, in a read/write process, polarization of a ferroelectric thin film is disturbed via the alternating current signal, to assist in polarization switching of the ferroelectric thin film, so that an operating voltage required for ferroelectric switching of the ferroelectric thin film can be reduced, damage caused by an electric field to the ferroelectric thin film is reduced, thereby improving endurance of a ferroelectric device.

Optionally, the signal control unit and the memory controller may be the signal control unit and the memory controller according to any implementation of the second aspect. Details are not described herein again.

According to a fifth aspect, a technical solution of this application provides a method for increasing endurance of a ferroelectric memory. The ferroelectric memory may be the ferroelectric memory according to the third aspect or any one of the implementations of the third aspect. The method includes:
The memory controller switches the signal input to the plate line to the alternating current signal through the signal control unit in a read/write interval of the ferroelectric memory cell.

Optionally, the switching the signal input to the plate line to the alternating current signal through the signal control unit includes: The memory controller sends a first enable signal to the signal control unit, where the first enable signal is used to control the signal control unit to input the alternating current signal to the plate line.

Optionally, the method further includes: The memory controller sends a second enable signal to the signal control unit in a read/write process of the ferroelectric memory cell, where the second enable signal is used to control the signal control unit to input the read/write pulse signal to the plate line.

According to a sixth aspect, a technical solution of this application provides a method for increasing endurance of a ferroelectric memory. The ferroelectric memory may be the ferroelectric memory according to the fourth aspect or any one of the implementations of the fourth aspect. The method includes:

The memory controller superimposes, through the signal control unit in a read/write process of the ferroelectric memory cell, the alternating current signal and the read/write pulse signal output by the memory controller, and inputs a superimposed signal to the plate line.

Optionally, the method further includes: The memory controller sends a first enable signal to the signal control unit, where the first enable signal is used to control the signal control unit to input the superimposed signal to the plate line.

According to a seventh aspect, a technical solution of this application provides an electronic device, including a mainboard, a processor coupled to the mainboard, and the ferroelectric memory according to the third aspect or the fourth aspect.

It may be understood that the third aspect and the fourth aspect provide the ferroelectric memory, and the method provided in the fifth aspect or the sixth aspect and the electronic device provided in the seventh aspect are all based on the control apparatus provided in the first aspect or the second aspect. Therefore, for beneficial effect that can be achieved, refer to the beneficial effect in the corresponding control apparatus. Details are not described herein again.

### BRIEF DESCRIPTION OF DRAWINGS

FIG. 1A is a schematic of a circuit structure of a ferroelectric memory cell of a 1T1C structure;
FIG. 1B is a schematic of a circuit structure of a ferroelectric memory cell of a 2T2C structure;
FIG. 1C is a schematic of a circuit structure of a ferroelectric memory cell of a 1T2C structure;
FIG. 2 is a diagram of a structure of a ferroelectric memory according to an embodiment of this application;
FIG. 3A is a diagram of distribution of oxygen defects of a deteriorated ferroelectric capacitor before and after an alternating current signal is applied according to an embodiment of this application;
FIG. 3B is a diagram of distribution of oxygen defects before and after a ferroelectric capacitor is annealed via an alternating current signal according to an embodiment of this application;
FIG. 4A and FIG. 4B are schematics of circuits of two ferroelectric memories according to an embodiment of this application;
FIG. 5 is a schematic of a circuit of another ferroelectric memory according to an embodiment of this application;
FIG. 6A is an example diagram of a voltage time sequence of a WL, a PL, a BL, and E during repairing a ferroelectric memory cell in a read/write interval according to an embodiment of this application;
FIG. 6B is an example diagram of a voltage time sequence of a WL, a PL, a BL, and E in a process of writing "0" according to an embodiment of this application;
FIG. 6C is an example diagram of a voltage time sequence of a WL, a PL, a BL, and E in a process of writing "1" according to an embodiment of this application;
FIG. 6D is an example diagram of a voltage time sequence of a WL, a PL, a BL, an SA, and E in a read operation process according to an embodiment of this application;
FIG. 7 is a schematic of a circuit of another ferroelectric memory according to an embodiment of this application;
FIG. 8 is a schematic of a circuit of another ferroelectric memory according to an embodiment of this application;
FIG. 9A is an example diagram of a voltage time sequence of a WL, a PL, a BL, and E during assisting in writing "0" via an alternating current signal according to an embodiment of this application;
FIG. 9B is an example diagram of a voltage time sequence of a WL, a PL, a BL, and E during assisting in writing " 1" via an alternating current signal according to an embodiment of this application;
FIG. 9C is an example diagram of a voltage time sequence of a WL, a PL, a BL, an SA, and E during assisting a read operation via an alternating current signal according to an embodiment of this application;
FIG. 10 is a schematic of a circuit of another ferroelectric memory according to an embodiment of this application;
FIG. 11 is a schematic flowchart of a method for increasing endurance of a ferroelectric memory according to an embodiment of this application; and
FIG. 12 is a diagram of a structure of an electronic device according to an embodiment of this application.

### DESCRIPTION OF EMBODIMENTS

First, technical terms used in embodiments of this application are described.
1. A ferroelectric memory cell is a minimum memory cell that can store 1-bit information, and may include but is not limited to the following several circuit structures.

### (1) One transistor and one capacitor (that is, 1T1C)

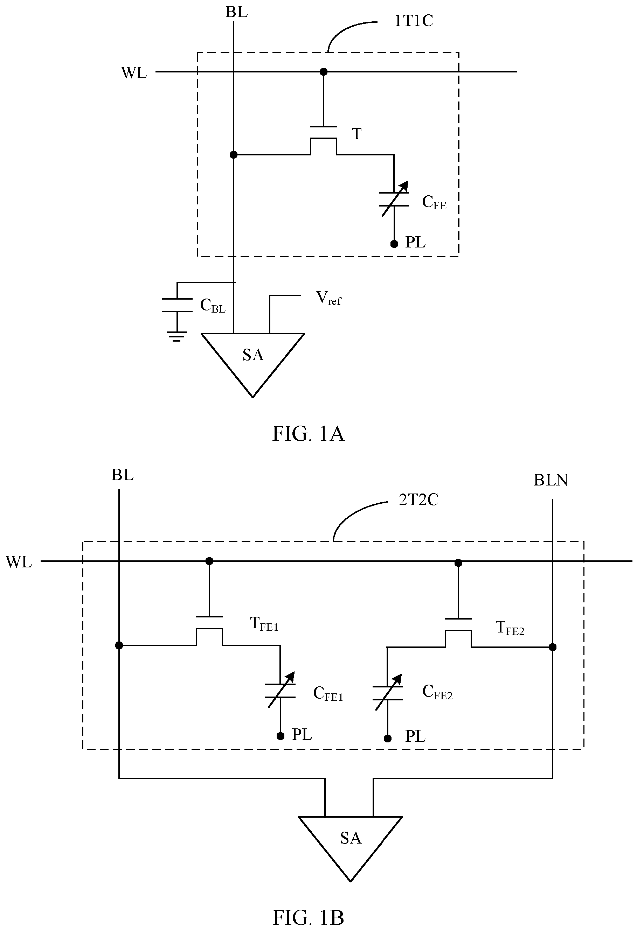

As shown in FIG. 1A, a ferroelectric memory cell of a 1T1C structure includes one transistor T and one ferroelectric capacitor C_{FE}, and a word line WL controls a switch of the transistor T. For example, the transistor T is a metal-oxide-semiconductor field-effect transistor (metal-oxide-semiconductor field-effect transistor, MOSFET). A gate of the transistor T is connected to the word line WL, a source and a drain of the transistor T are connected to a bit line BL and one end of the ferroelectric capacitor C_{FE} respectively, and the other end of the ferroelectric capacitor C_{FE} is connected to a plate line PL. The bit line BL and a reference potential Vref are input to a sense amplifier SA, and C_{BL} is a parasitic capacitor. The 1T1C-type ferroelectric memory cell includes one transistor and one capacitor, and therefore it has a higher integration level.

### (2) Two transistors and two capacitors (that is, 2T2C)

As shown in FIG. 1B, a ferroelectric memory cell of a 2T2C structure includes two transistors (T_{FE1} and T_{FE2}) and two ferroelectric capacitors (C_{FE1} and C_{FE2}). 2T2C includes two bit lines: BL and BLN. C_{FE1} and C_{FE2} are load capacitors of the bit lines respectively, and are separately connected between one bit line and one PL. A word line WL controls switching of the transistors T_{FE1} and T_{FE2}. MOSFET is used as an example. Gates of both T_{FE1} and T_{FE2} are connected to the word line WL, a source and a drain of T_{FE1} are connected to the bit line BL and one end of the ferroelectric capacitor C_{FE1} respectively, and the other end of the ferroelectric capacitor C_{FE1} is connected to the plate line PL. A source and a drain of T_{FE2} are connected to the bit line BLN and one end of the ferroelectric capacitor C_{FE2} respectively, and the other end of the ferroelectric capacitor C_{FE2} is connected to the plate line PL.

### (3) One transistor and two capacitors (that is, 1T2C)

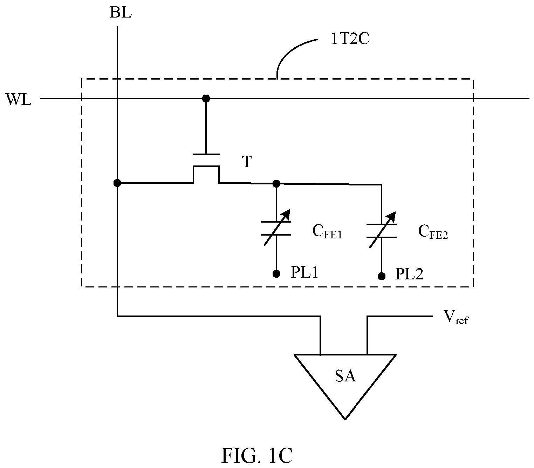

As shown in FIG. 1C, a ferroelectric memory cell of a 1T2C structure includes one transistor (T) and two ferroelectric capacitors (C_{FE1} and C_{FE2}). 1T2C includes two plate lines: PL₁ and PL₂. C_{FE1} and C_{FE2} are load capacitors of a bit line, and are separately connected between one PL and the bit line BL. A word line WL controls a switch of the transistor T. MOSFET is used as an example. A gate of T is connected to the word line WL, a source and a drain of T are connected to the bit line BL and ends of the two ferroelectric capacitors respectively, and the other end of C_{FE1} and the other end of C_{FE2} are connected to PL₁ and PL₂ respectively.

It should be understood that the ferroelectric memory cell in a ferroelectric memory forms a three-dimensional array. If one layer of array is referred to as one memory array, the ferroelectric memory cell includes a plurality of memory arrays. The bit line and the word line are used to determine a position of a ferroelectric memory cell, in the memory array, on which reading or writing is to be performed, that is, a row and a column in the memory array. The plate line is used to determine a memory array in which a ferroelectric memory cell on which reading/writing is to be performed is located. The bit line and the word line are selected by a bit line decoder and a word line decoder respectively, and the plate line is selected by a plate line decoder. In addition, the selected (also referred to as activated) plate line, bit line, and word line may determine a unique ferroelectric memory. In this case, a voltage time sequence sent by a memory controller is input to the selected plate line, bit line, and word line, to complete a read or write operation on the selected ferroelectric memory cell. In embodiments of this application, the voltage time sequence input by the memory controller to the plate line is also referred to as a read/write pulse signal.

2. A structure of a ferroelectric capacitor may include but is not limited to a stacking structure of an MFM, an MFIM, an MFIFM, and an MFIS. M refers to metal, and is an electrode of the ferroelectric capacitor. F refers to a ferroelectric material, I refers to an insulation material, and both are dielectrics of the ferroelectric capacitor. S refers to a semiconductor material, and may be used as an electrode of the ferroelectric capacitor.

3. A ferroelectric material in the ferroelectric capacitor in embodiments of this application may be a hafnium oxide-based material, for example, hafnium oxide or doped hafnium oxide. A doping material includes but is not limited to one or more of silicon Si, gadolinium Gd, strontium Sr, yttrium Y, lanthanum La, aluminum Al, zirconium Zr, cerium Ce, and the like. For example, the ferroelectric material is zirconium hafnium oxide Hf₁₋ₓZrₓO₂, where 0.01<x<1 or 0.3≤x≤0.5.

4. A "read/write interval" in embodiments of this application refers to a time period when no read operation is performed and no write operation is performed on the ferroelectric memory cell. A "read/write process" refers to a time period when a read operation and/or a write operation is performed on the ferroelectric memory cell, including a read process or a write process. "Read/write" refers to a read operation and/or a write operation.

The following describes a complex mechanism of performance deterioration and even device failure in repeated read/write processes of the ferroelectric memory device.

When the ferroelectric memory device operates under a high electric field strength, as a quantity of read/write times increases, a stress caused by a large electric field causes defects (for example, an oxygen vacancy) in a ferroelectric thin film, to pin a ferroelectric domain, thereby causing unrecoverable deterioration of ferroelectric performance.

When the ferroelectric memory device operates under a medium electric field strength, a weak electric field strength causes incomplete switching of ferroelectric polarization in the read/write process. A ferroelectric domain that is not switched causes defect generation, movement, and aggregation. As a result, some ferroelectric domains are pined and more difficult to be switched. In terms of electrical properties, a ferroelectric current has two or more peaks with an increase of a voltage, that is, a split-up (split-up) phenomenon, and consequently the ferroelectric performance deteriorates. The split-up phenomena can recover partial ferroelectric performance by applying the large electric field to merge (merge) the plurality of split-up peaks.

When the ferroelectric memory device operates under a weak electric field strength, a weak electric field stress can reduce defect generation in the read/write process, so that the device failure caused by the defect is weakened. In this condition, charge trapping (charge trapping) is a main factor that leads to deterioration of the ferroelectric performance. As the quantity of read/write times increases, the ferroelectric performance deteriorates due to charge trapping accumulation. The ferroelectric performance can be recovered by applying the large electric field to drive a charge to move.

Therefore, for the mechanism of the failure of the ferroelectric device in the repeated read/write processes, an additional method may be introduced based on a present material in an operating process of the device, to recover losses of the ferroelectric performance of the device, so as to further extend endurance of the device based on the present material.

Damage, such as charge injection and defect generation, caused by an external bias voltage to a ferroelectric functional layer (that is, a ferroelectric material layer) of the device can be recovered to some extent through thermal annealing, so that impact of the damage on the ferroelectric performance of the device is weakened and endurance of the device is improved. However, it is impossible to perform external thermal annealing on a commercial memory, and only Joule heat generated by a current can be used to enable the commercial memory to achieve effect of thermal annealing. However, the method in which Joule heat is used for annealing can only be applied to FeFET, but cannot be applied to a ferroelectric memory device of an MFM structure. An application scenario is very limited.

If a small voltage (for example, ±3 MV/cm) is used to read/write a ferroelectric status, and a low-frequency large voltage pulse (kilohertz magnitude) is applied when the ferroelectric performance deteriorates, the ferroelectric performance of the device is recovered. As mentioned above, when the ferroelectric thin film operates at a low voltage, oxygen vacancy aggregation and charge trapping are main factors that cause the failure of the ferroelectric memory device. The low-frequency large voltage pulse (such as ±5 MV/cm) can be used to effectively drive oxygen vacancies in the ferroelectric thin film to redistribute and reduce charge trapping effect, so that the ferroelectric performance of the device is recovered. However, the low-frequency large voltage pulse can only be used to recover deterioration of the ferroelectric performance caused by problems such as oxygen vacancy accumulation and charge trapping at the low operating voltage, and cannot be used to solve problems such as oxygen vacancy generation and defect generation, that is, cannot be used to reduce the oxygen vacancy. Therefore, the ferroelectric device needs to operate at the low voltage, and it is difficult to obtain high remnant polarization. In addition, a low-frequency high voltage further introduces defects such as an oxygen vacancy. This makes it difficult to recover the ferroelectric performance of the device after a specific quantity of read/write times.

To alleviate performance degradation of a hafnium oxide-based ferroelectric memory during repeated reading/writing, to enable the hafnium oxide-based ferroelectric memory to continuously maintain good ferroelectric performance, and further show good endurance, an embodiment of this application provides a ferroelectric memory and a method for increasing endurance of the ferroelectric memory. In a read/write process or a read/write interval of the ferroelectric memory, a high-frequency alternating current signal is used for assisting, performance degradation of the device caused by defect generation and charge trapping is alleviated, and endurance of the device is effectively prolonged.

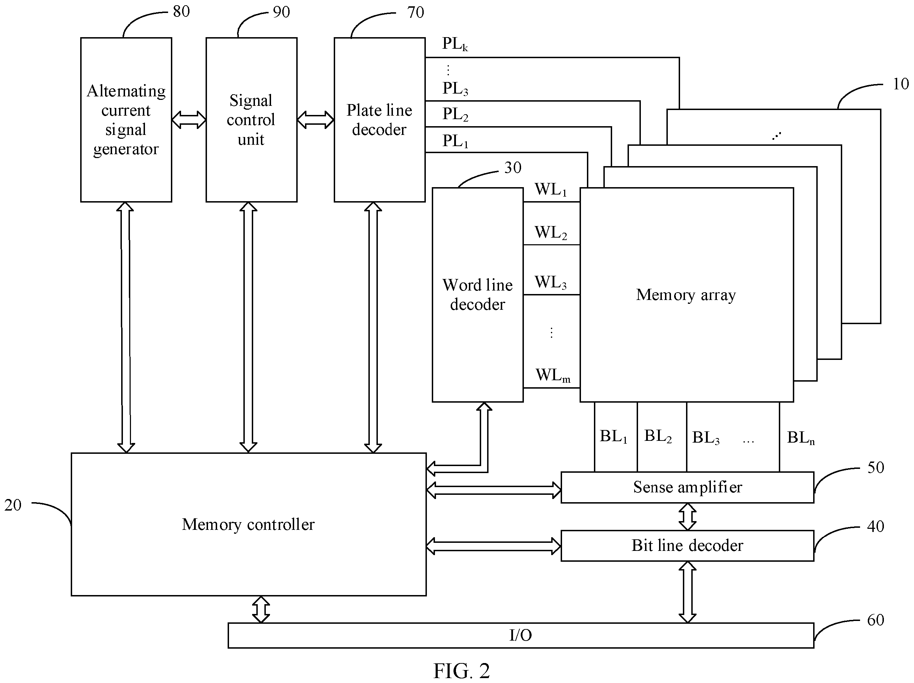

FIG. 2 is a diagram of a structure of a ferroelectric memory according to an embodiment of this application. The ferroelectric memory may include some or all of at least one memory array 10, a memory controller 20, a word line decoder 30, a bit line decoder 40, a sense amplifier 50, an input/output interface (I/O) 60, a plate line decoder 70, an alternating current signal generator 80, a signal control unit 90, and the like.

k memory arrays 10 are used as an example for description, and k is a positive integer. Each memory array 10 may include a plurality of ferroelectric memory cells arranged in arrays. The ferroelectric memory cell may be of each of 1T1C, 2T2C, and 1T2C circuit structures shown in FIG. 1A to FIG. 1C. For details, refer to related descriptions in FIG. 1A to FIG. 1C. Details are not described herein again. One memory array 10 includes one or more PLs. One PL is used as an example, k memory arrays 10 include k PLs, that is, PL₁, PL₂, PL₃, ..., PLₖ. The k PLs are all coupled to the signal control unit 90.

The ferroelectric memory cell of the 1T1C circuit structure is used as an example. Each ferroelectric memory cell is coupled to one word line WL and one bit line BL. For an m×n memory array 10, each memory array 10 includes m rows and n columns of ferroelectric memory cells, each row of ferroelectric memory cells share a same WL, and each column of ferroelectric memory cells share a same BL. In this case, the memory array 10 includes m word lines WLs, which are WL₁, WL₂, WL₃, ..., and WLₘ respectively, and n bit lines BLs, which are BL₁, BL₂, BL₃, ..., and BLₘ respectively. Both m and n are positive integers. For example, m=8, n=64, and a memory capacity of one memory array 10 is 512 bits. It should be further understood that a plurality of memory arrays 10 may also share the WL and the BL.

Each word line WL is coupled to the word line decoder 30. The word line decoder 30 is configured to select a WL, that is, activate the WL, based on a physical address on which reading/writing is to be performed, so that transistors in a row of ferroelectric memory cells (that is, ferroelectric memory cells connected to the activated WL) in which ferroelectric memory cells on which reading/writing is to be performed are located are all turned on.

Each bit line BL is coupled to the sense amplifier 50 to amplify a voltage of data read from the memory array. The sense amplifier 50 is coupled to the bit line decoder 40. The bit line decoder 40 is configured to select a BL, that is, activate the BL, based on a physical address on which reading/writing is to be performed, so that a ferroelectric memory cell on which reading is to be performed transmits data in the ferroelectric memory cell on which reading is to be performed to an I/O through a BL connected to the ferroelectric memory cell on which reading is to be performed, or writes data into a ferroelectric memory cell on which writing is to be performed.

For the ferroelectric memory cell of the 1T1C structure, one memory array 10 is coupled to one PL, and each PL is coupled to the plate line decoder 70. The plate line decoder 70 is configured to select a PL, that is, activate the PL, based on a physical address on which reading/writing is to be performed to select a memory array 10 in which a ferroelectric memory cell on which reading/writing is to be performed is located.

The alternating current signal generator 80 is configured to generate an alternating current signal. A frequency and an amplitude of the alternating current signal generated by the alternating current signal generator 80 may be fixed, or may be changed based on a to-be-performed operation, a damage degree of the ferroelectric capacitor, use duration of the ferroelectric memory, or the like.

For example, in a read/write interval, if the ferroelectric memory cell needs to be repaired, a first alternating current signal is output; and when reading or writing needs to be performed, a second alternating current signal is output.

For another example, when the damage degree of the ferroelectric capacitor is small or the use duration of the ferroelectric memory is small, the amplitude or the frequency of the alternating current signal may be small, to prevent damage caused by a large-amplitude alternating current signal to the capacitor. On the contrary, when the damage degree of the ferroelectric capacitor is serious or the use duration of the ferroelectric memory is long, the amplitude of the alternating current signal is large, to accelerate repair.

The signal control unit 90 is coupled to the plate line decoder 70. The signal control unit 90 is configured to control a signal input to the PL.

In some embodiments, the signal control unit 90 is configured to control, based on an enable signal of the memory controller 20, whether the signal input to the PL is a read/write pulse signal or an alternating current signal generated by the alternating current signal generator 80.

Specifically, the memory controller 20 is configured to activate, in a read/write process of the ferroelectric memory cell, a bit line and a word line that are coupled to the ferroelectric memory cell, and send an enable signal E₁ to the signal control unit 90. The signal control unit 90 is configured to control, based on the enable signal E₁, the signal input to the PL to be a read/write pulse signal, where the read/write pulse signal is used to write data into the ferroelectric memory cell.

For example, when a write request for the ferroelectric memory cell is received, the read/write pulse signal is used to write data indicated by a read request into the ferroelectric memory cell.

For another example, when a read request for the ferroelectric memory cell is received, the read/write pulse signal is used to read data and write, after the data is read, the data read by the ferroelectric memory cell, that is, data originally stored by the ferroelectric memory cell, into the ferroelectric memory cell.

The memory controller 20 is further configured to activate, in a read/write interval of the ferroelectric memory cell, a bit line and a word line that are coupled to the ferroelectric memory cell, and send an enable signal E₂ to the signal control unit 90. The signal control unit 90 is configured to control, based on the enable signal E₂, the signal input to the PL to be an alternating current signal, to repair the ferroelectric memory cell in the read/write interval.

In some other embodiments, the signal control unit 90 is configured to superimpose the alternating current signal and the read/write pulse signal, and input a superimposed signal to the plate line, to assist in polarization switching of a ferroelectric thin film when reading/writing is performed on the ferroelectric capacitor, so that an operating voltage required for ferroelectric switching of the ferroelectric thin film can be reduced, damage caused by an electric field to the ferroelectric thin film is reduced, thereby improving endurance of a ferroelectric device. Specifically, in a read/write process of the ferroelectric memory cell, the signal input to the selected PL is controlled to be superimposition of the alternating current signal and the read/write pulse signal, to repair, in the read/write process, the ferroelectric memory cell on which writing is to be performed.

Specifically, the memory controller 20 activates, in a read/write interval of the ferroelectric memory cell, a bit line and a word line that are coupled to the ferroelectric memory cell, and send an enable signal E₃ to the signal control unit 90. The signal control unit 90 is configured to control, based on the enable signal E₃, the signal input to the PL to be an alternating current signal, to repair the ferroelectric memory cell in the read/write interval.

In some other embodiments, the signal control unit 90 may not only be configured to control, based on an enable signal of the memory controller 20, whether the signal input to the PL is a read/write pulse signal, an alternating current signal generated by the alternating current signal generator 80, or superimposition of the alternating current signal and the read/write pulse signal. In this case, the ferroelectric memory cell may be repaired in both a read/write interval and a read/write process of the ferroelectric memory cell.

It should be understood that the memory controller 20 is configured to control normal operating of modules in the memory controller. Specifically, the memory controller 20 may generate a signal used to activate the PL, the WL, and the BL, to activate, by using the plate line decoder 70, the word line decoder 30, the bit line decoder 40, the sense amplifier 50, the signal control unit 90, and the like, the ferroelectric memory cell on which reading/writing is to be performed, and control a read operation or a write operation on the ferroelectric memory cell in the memory array 10. The memory controller 20 may further control the alternating current signal generator 80 to generate an alternating current signal.

It should be further understood that, for a mechanism, a principle, and a method in which the memory controller 20 may further repair the ferroelectric memory cell in the memory array 10 in the read/write process and/or the read/write interval, refer to the following Embodiment 1, Embodiment 2, and Embodiment 3.

It should be noted that the word line decoder 30 may also be referred to as a row decoder, a row decoding unit, or the like, and the bit line decoder 40 may also be referred to as a column decoder, a column decoding unit, or the like. It should be further noted that, not limited to the modules or units in FIG. 2, the ferroelectric memory may further include more or fewer modules or units.

The following describes the mechanism, the principle, and the method for repairing the ferroelectric memory via the alternating current signal in three embodiments.

### Embodiment 1

First, a ferroelectric capacitor of an MFM structure is used as an example to describe a mechanism for repairing a ferroelectric memory via an alternating current signal in Embodiment 1, to increase endurance of the ferroelectric memory.

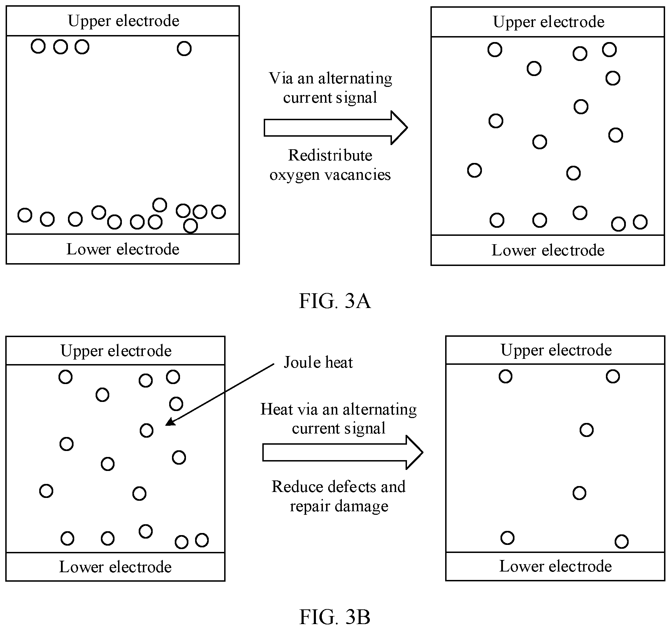

After being repeatedly read/written, the ferroelectric memory undergoes deterioration, such as defect generation and charge trapping. FIG. 3A is a diagram of distribution of oxygen defects of a deteriorated ferroelectric capacitor before and after an alternating current signal is applied according to an embodiment of this application. The deteriorated ferroelectric capacitor generates a large quantity of oxygen vacancies, and the oxygen vacancies are distributed on two sides that are of a ferroelectric thin film (that is, a ferroelectric material layer) and that are close to an upper electrode and a lower electrode. In a read/write interval of the ferroelectric memory cell, a high-frequency positive and negative alternating voltage signal (that is, the alternating current signal) applied to two ends of the ferroelectric capacitor can effectively drive the oxygen vacancies in the ferroelectric thin film to move and redistribute, so that the oxygen vacancies are distributed more evenly in the ferroelectric thin film. Further, when the high-frequency alternating current signal is injected into a ferroelectric device, a voltage is applied to the device for a short time, and an electrical stress (stress) applied to the ferroelectric thin film is small. Therefore, the high-frequency alternating current signal is used, so that the oxygen vacancies are driven to be redistributed and defects such as an oxygen vacancy are not introduced.

In addition, alternatively, the high-frequency alternating current signal may be used, so that electrons in the ferroelectric thin film up and down are repeatedly moved, to generate joule heat, so as to heat the ferroelectric thin film and implement annealing driven by electricity. This reduces defects in the ferroelectric thin film and repairs material damage caused by repeated reading/writing. FIG. 3B is a diagram of distribution of oxygen defects before and after a ferroelectric capacitor is annealed via an alternating current signal according to an embodiment of this application. When the alternating current signal is applied to two ends of the ferroelectric capacitor, electrons in the ferroelectric capacitor may be driven to move back and forth, to generate joule heat, so as to heat a ferroelectric thin film. When the alternating current signal is not applied, the ferroelectric thin film cools, to achieve annealing effect, so as to reduce oxygen vacancies generated by the ferroelectric thin film.

Therefore, a high-frequency alternating current signal is applied to the two ends of the ferroelectric capacitor, so that redistribution of the oxygen vacancies is promoted and oxygen vacancies that have been generated are reduced.

A frequency of the alternating current signal in Embodiment 1 of this application is 0.1 MHz to 10 GHz, and an amplitude may be equal to an amplitude of a read/write pulse signal, or may be greater than or less than an amplitude of the read/write pulse signal, for example, 0.5 to 10 times the amplitude of the read/write pulse signal. Preferably, the frequency of the alternating current signal is 10 MHz to 1 GHZ, and the amplitude of the alternating current signal is equal to or 0.8 times, 1 time, 1.5 times, 2 times, or 3 times the amplitude of the read/write pulse signal.

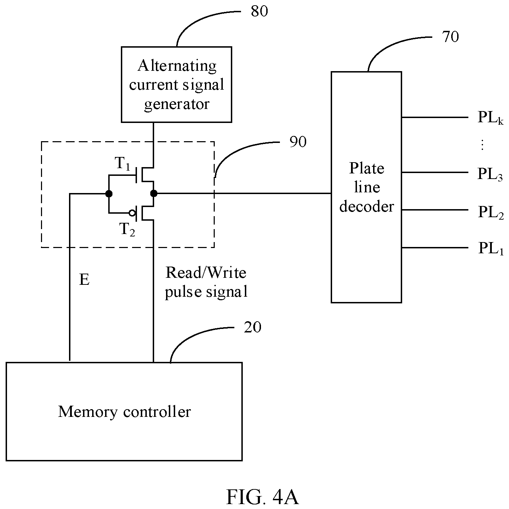

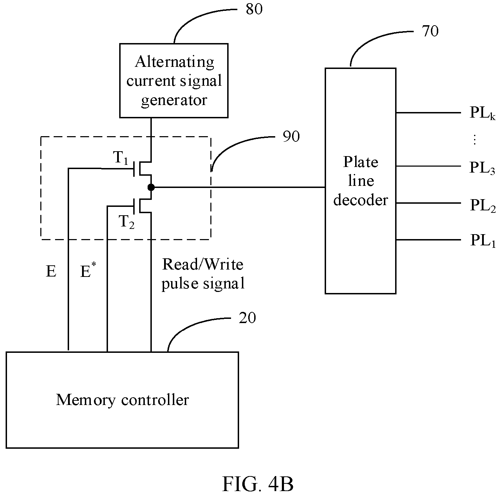

FIG. 4A and FIG. 4B are schematics of circuits of two ferroelectric memories according to Embodiment 1 of this application.

As shown in FIG. 4A and FIG. 4B, the signal control unit 90 may include a first switching transistor T1 and a second switching transistor T2. The first switching transistor T1 and the second switching transistor T2 are connected in series, and are configured to control signals input to the plate line decoder 70. A first end of T1 is coupled to the alternating current signal generator 80 to receive an alternating current signal, and a second end of T1 is coupled to a first end of T2. A second end of T2 is coupled to the memory controller 20, to receive a read/write pulse signal. A common end connected to the second end of T1 and the first end of T2 is connected to the plate line decoder 70, and the plate line decoder 70 connects the common end to one of PLs based on an address sent by the memory controller 20.

As shown in FIG. 4A, T1 and T2 are transistors of different conductivity types, one is a P-type transistor, and the other is an N-type transistor. For example, the transistor is a MOS transistor, and gates of T1 and T2 are connected to and are coupled to the memory controller 20. An enable signal E output by the memory controller 20 enables T2 to be turned off when T1 is turned on, and vice versa, T1 to be turned on when T2 is turned off.

As shown in FIG. 4B, T1 and T2 are transistors of a same conductivity type, and both are P-type transistors or N-type transistors. For example, the transistor is a MOS transistor, and gates of T1 and T2 are coupled to the memory controller 20, to receive enable signals E and E* from the memory controller respectively. Polarities of E and E* are opposite, so that when T1 is turned on, T2 is turned off; and vice versa, when T2 is turned off, T1 is turned on.

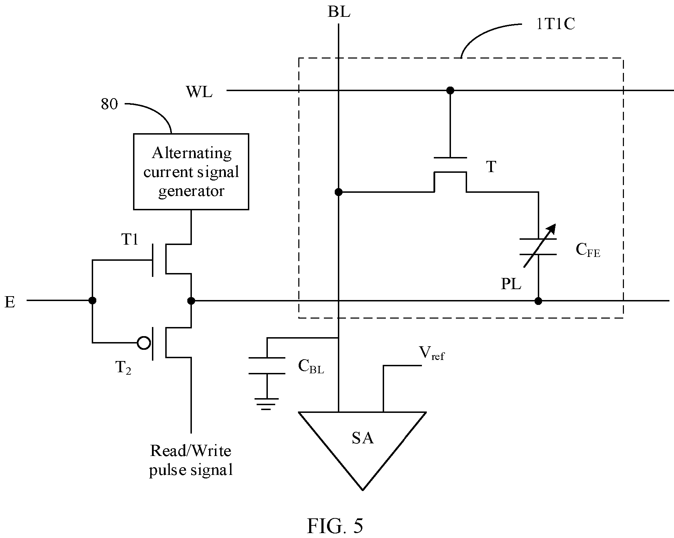

FIG. 5 is a schematic of a circuit of a ferroelectric memory by using an example in which the ferroelectric memory cell in the memory controller shown in FIG. 4A is of a 1T1C circuit structure. FIG. 5 shows only one ferroelectric memory cell. It should be understood that the ferroelectric memory may include one or more memory arrays, and each memory array may include one or more ferroelectric memory cells. The ferroelectric memory activates, based on a ferroelectric memory cell that needs to be operated or repaired, a WL, a BL, and a PL that are coupled to the ferroelectric memory cell.

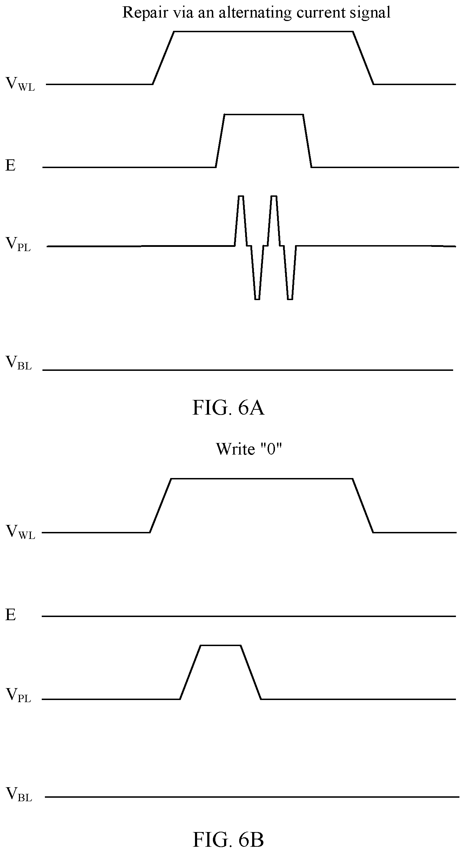

As shown in FIG. 6A, an example in which both T1 and a transistor in the ferroelectric memory cell are N-type transistors is used to show a voltage time sequence of a WL, a PL, a BL, and E of the ferroelectric memory cell shown in FIG. 4A in a read/write interval. In the read/write interval of the ferroelectric memory cell, the memory controller 20 selects the voltage time sequence input into a WL, a BL, and a PL that are coupled to the ferroelectric memory cell shown in FIG. 6A, to turn on a transistor T in the ferroelectric memory cell, and sends an enable signal E₁ to a control end E of the signal control unit 90, that is, inputs high levels to gates of T1 and T2, to turn on T1 and turn off T2. Input of the PL is switched to the alternating current signal generator, and an alternating current signal output by the alternating current signal generator is applied to two ends of the ferroelectric capacitor C_{FE} to repair C_{FE}.

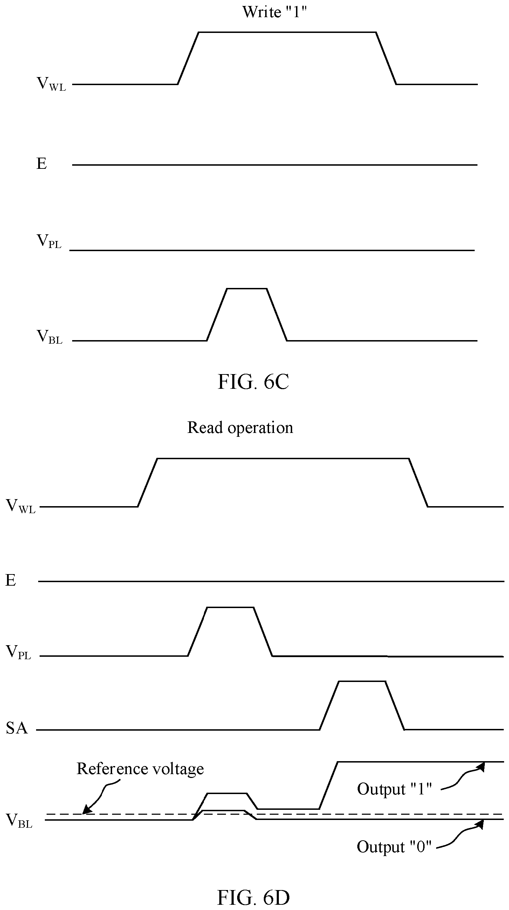

As shown in FIG. 6B, an example in which both T1 and a transistor in the ferroelectric memory cell are N-type transistors is used to show a voltage time sequence of a WL, a PL, a BL, and E in a process of writing "0" into the ferroelectric memory cell shown in FIG. 4A. FIG. 6C shows a voltage time sequence of a WL, a PL, a BL, and E in a process of writing "1" to the ferroelectric memory cell shown in FIG. 4A. In a write process, the memory controller 20 selects a WL, a BL, and a PL that are coupled to a ferroelectric memory cell on which an operation is to be performed, to turn on a transistor T in the ferroelectric memory cell, and sends an enable signal E₂ to a control end E of the signal control unit 90, that is, inputs low levels to gates of T1 and T2, to turn on T2 and turn off T1. Input of the PL is switched to the memory controller 20, so that a read/write pulse signal is input to the PL and applied to the ferroelectric capacitor C_{FE}. Therefore, a polarity of C_{FE} is switched, to complete a write operation.

FIG. 6D shows a voltage time sequence of a WL, a PL, a BL, an SA, and E in a read operation process of the ferroelectric memory cell shown in FIG. 4A.

In a read process, a control end E of the signal control unit 90 inputs an enable signal E₂, that is, inputs low levels to gates of T1 and T2, to turn on T2 and turn off T1. Input of the PL is switched to the memory controller 20. The memory controller 20 selects a WL, a BL, and a PL that are coupled to a ferroelectric memory cell on which reading is to be performed, to turn on a transistor T in the ferroelectric memory cell, so that a read/write pulse signal is input to the PL, and the PL changes to a high level. If data stored in the ferroelectric memory cell is "0", a polarity of a ferroelectric material is not switched, and the ferroelectric capacitor is not discharged; or if the data stored in the ferroelectric memory cell is "1", the polarity of the ferroelectric material is switched, and the ferroelectric capacitor is discharged. In this case, a low level is input to the PL, and the sense amplifier SA is turned on. The SA compares a voltage on the BL with a reference voltage. If the voltage on the BL is greater than the reference voltage, a high level is output, that is, "1" is read. If the voltage on the BL is less than the reference voltage, a low level is output, that is, "0" is read. When the read data is "1", the ferroelectric capacitor C_{FE} is damaged. Therefore, the data " 1" further needs to be written back to the ferroelectric memory cell (not shown in FIG. 6D). When "1" is written back, the SA does not need to be turned on. A principle of writing " 1" is the same as that of writing "1" shown in FIG. 6C. Details are not described herein again.

It should be understood that, in FIG. 6D, a voltage on the BL after the SA is turned on is not an actual voltage on the BL, but is an output voltage obtained after the SA compares the voltage on the BL with the reference voltage.

In some embodiments, for the ferroelectric memory shown in FIG. 4B, for example, both T1 and T2 are N-type transistors, in a read/write interval of the ferroelectric memory cell, the memory controller 20 activates a WL, a BL, and a PL that are coupled to the ferroelectric memory cell, to turn on a transistor T in the ferroelectric memory cell, sends a first signal to a gate of the first switching transistor T1, that is, a high level, to turn on T1, and sends a second signal to a gate of the second switching transistor T2, that is, a low level, to turn off T2. Input of the PL is switched to the alternating current signal generator, and the alternating current signal generator outputs an alternating current signal to the ferroelectric capacitor C_{FE} to repair C_{FE}. However, in a read/write process, the memory controller 20 activates a WL, a BL, and a PL that are coupled to a ferroelectric memory cell on which an operation is to be performed, to turn on a transistor T in the ferroelectric memory cell, sends a third signal, that is, a low level, to a gate of T1, to turn off T1, and sends a fourth signal, that is, a high level, to a gate of T2, to turn on the second switching transistor T2. Input of the PL is switched to the memory controller 20, so that a read/write pulse signal is applied to the ferroelectric capacitor C_{FE} to charge/discharge C_{FE}, to complete a read/write operation.

In Embodiment 1, after the ferroelectric device is repeatedly read/written for a plurality of times, and ferroelectric performance of the ferroelectric device deteriorates to a specific extent, for deterioration of the ferroelectric performance caused by oxygen vacancy migration, aggregation, and charge trapping, the high-frequency alternating current signal (1 MHz to 1 GHz) is injected into the ferroelectric capacitor. Alternating current signals with constantly changing polarities are applied to the upper and lower electrodes of the ferroelectric capacitor, to drive the defect, the oxygen vacancy, and the like in the ferroelectric thin film to move away from balanced positions under driving of an alternating electric field to finally implement redistribution. This recovers ferroelectric performance of the ferroelectric thin film to a good level.

In addition, a high frequency makes the electric field apply for a short time, so that defect generation caused by an electric field stress can be effectively avoided.

In addition, for unrecoverable defect generation that occurs in the repeated read/write processes, the frequency (1 GHz to 10 GHz) of the alternating current signal is increased, so that dipole molecules in the ferroelectric thin film are reciprocated at a high frequency, and internal friction heat is generated. Therefore, the ferroelectric thin film is heated, a thermal annealing function is achieved, damage in the ferroelectric thin film is repaired, and ferroelectric performance of the ferroelectric thin film is recovered to a good level. In conclusion, the frequency and an amplitude of the alternating current signal are controlled, so that thermal annealing effect and oxygen vacancy redistribution effect of the alternating current signal on the ferroelectric capacitor may be separately controlled. This can effectively alleviate performance deterioration of the ferroelectric device and increase endurance of the device.

### Embodiment 2

A ferroelectric memory may be damaged in a read/write process, especially when the ferroelectric memory operates in a large electric field strength. A stress caused by the large electric field causes defects (for example, an oxygen vacancy) in a ferroelectric thin film, to pin a ferroelectric domain, thereby causing unrecoverable deterioration of ferroelectric performance.

To reduce damage caused by the ferroelectric thin film in the read/write process, in Embodiment 2 of this application, a low-voltage alternating current signal is used to assist in polarization switching of the ferroelectric thin film in the read/write process. Specifically, a signal obtained after an alternating current signal and a read/write pulse signal are superimposed is used to drive polarization switching of the ferroelectric thin film, to implement polarization switching of the ferroelectric thin film in a small electric field strength.

This is because the low-voltage alternating current signal can drive an electric polarization vector in the ferroelectric thin film to deviate from a balanced position and vibrate around the balanced position. When an applied alternating current signal is close to an eigenfrequency of an electric dipole moment, an external alternating current signal may resonate with the electric polarization vector, so that the electric polarization vector obtains a large amplitude. In this case, only a small drive voltage is required to drive polarization switching of the ferroelectric thin film. In this case, a low operating voltage may be used, and a decrease of the operating voltage may reduce damage of the ferroelectric thin film in the read/write process, so that endurance of the ferroelectric thin film is effectively increased.

In this embodiment of this application, a frequency of the alternating current signal is greater than a frequency of the read/write pulse signal, and may be twice, four times, or another multiple of the frequency of the read/write pulse signal. An amplitude of the alternating current signal is less than 1/2 of an amplitude of the read/write pulse signal, for example, 0.15, 0.2, or 0.25 times of the amplitude of the read/write pulse signal.

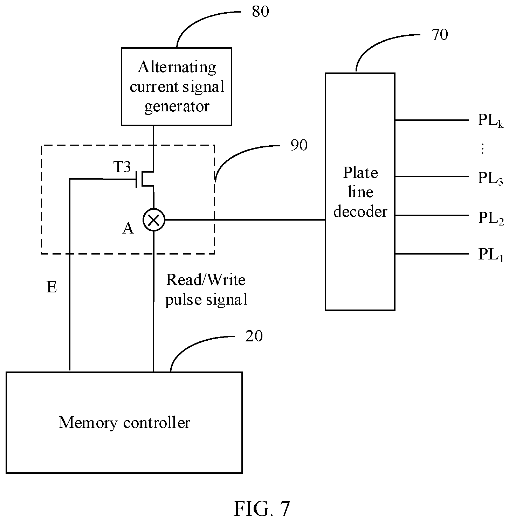

FIG. 7 is a schematic of a circuit of another ferroelectric memory according to an embodiment of this application. The signal control unit 90 may include a third switching transistor T3 and a multiplier A. An enable signal sent by the memory controller 20 controls T3 to be turned on or turned off, to control whether a signal input to the plate line is an alternating current signal or superimposition of the alternating current signal and a read/write pulse signal. A first end of T3 is coupled to the alternating current signal generator 80 to receive the alternating current signal, and a second end of T3 is coupled to a first input end of the multiplier A. A second input end of the multiplier A is coupled to the memory controller 20 to receive the read/write pulse signal. An output end of the multiplier A is coupled to the plate line decoder 70, and the multiplier A is configured to superimpose the alternating current signal and the read/write pulse signal. The plate line decoder 70 connects an output end of the multiplier A to one of PLs based on an address sent by the memory controller 20, to write data to the ferroelectric memory cell based on a superimposed read/write pulse signal.

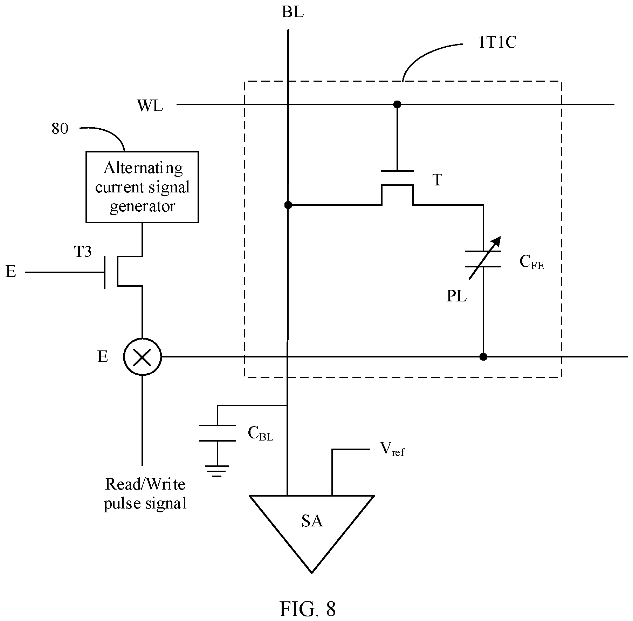

FIG. 8 is a schematic of a circuit of a ferroelectric memory by using an example in which the ferroelectric memory cell is of a 1T1C circuit structure. FIG. 8 shows only one ferroelectric memory cell. It should be understood that the ferroelectric memory may include one or more memory arrays, and each memory array may include one or more ferroelectric memory cells.

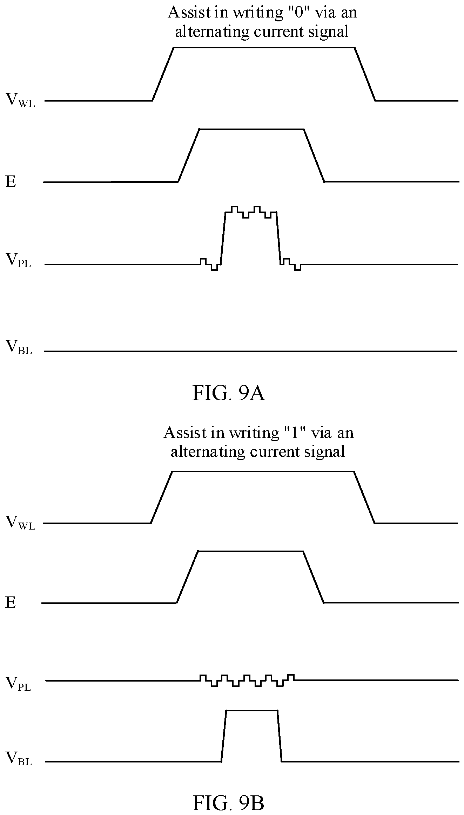

As shown in FIG. 9A, an example in which both T3 and a transistor in the ferroelectric memory cell are N-type transistors is used to show a voltage time sequence of a WL, a PL, a BL, and E during assisting in writing "0" via an alternating current signal. FIG. 9B shows a voltage time sequence of a WL, a PL, a BL, and E during assisting in writing "1" via an alternating current signal. In a read/write process of the ferroelectric memory cell, if the alternating current signal needs to be used to assist in switching of a ferroelectric thin film, the memory controller 20 activates a WL, a BL, and a PL that are coupled to the ferroelectric memory cell, to turn on a transistor T in the ferroelectric memory cell, and sends an enable signal E₃ to the signal control unit 90, that is, inputs a high level to a gate of T3, to turn on T3. Input of the PL is superimposition of the alternating current signal and a read/write pulse signal. A superimposed read/write pulse signal is applied to the ferroelectric capacitor C_{FE}, so that polarization switching of the ferroelectric thin film in C_{FE} occurs, to complete a write operation.

In some embodiments, polarity switching is not necessary assisted via the alternating current signal each time when writing is performed on the ferroelectric memory cell. For a voltage time sequence that is not written via the alternating current signal, refer to FIG. 6B and FIG. 6C. Details are not described herein again.

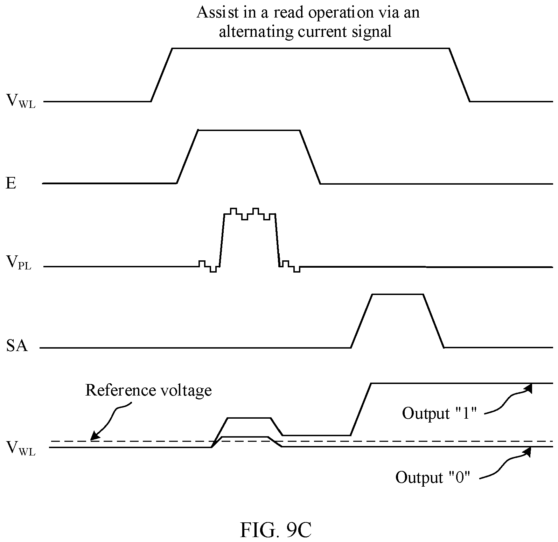

As shown in FIG. 9C, a voltage time sequence of a WL, a PL, a BL, an SA, and E is shown during assisting in a read operation via an alternating current signal.

In a read process, the memory controller 20 selects a WL, a BL, and a PL that are coupled to a ferroelectric memory cell on which reading is to be performed, to turn on a transistor T in the ferroelectric memory cell, and inputs an enable signal E₄ to a control end E of the signal control unit 90, that is, inputs a high level to a gate of T3, to turn on T3, so that a read/write pulse signal is superimposed with the alternating current signal, and then is input to the PL, and the PL changes to the high level. If data stored in the ferroelectric memory cell is "0", a polarity of a ferroelectric material is not switched, and the ferroelectric capacitor is not discharged; or if the data stored in the ferroelectric memory cell is "1", the polarity of the ferroelectric material is switched, and the ferroelectric capacitor is discharged. In this case, a low level is input to the PL, and the sense amplifier SA is turned on. The SA compares a voltage on the BL with a reference voltage. If the voltage on the BL is greater than the reference voltage, a high level is output, that is, "1" is read. If the voltage on the BL is less than the reference voltage, a high level is output, that is, "1" is read. When the read data is "1", the ferroelectric capacitor C_{FE} is damaged. Therefore, the data "1" further needs to be written back to the ferroelectric memory cell (not shown in FIG. 9C). When "1" is written back, the SA does not need to be turned on. A principle of writing "1" is the same as that of writing "1" shown in FIG. 6C or FIG. 9B. Details are not described herein again.

It should be understood that, when "1" is written back, polarity switching of the ferroelectric material may be assisted via the alternating current signal, or may not be assisted via the alternating current signal.

It should be further understood that, in FIG. 9C, a voltage on the BL after the SA is turned on is not an actual voltage on the BL, but is an output voltage obtained after the SA compares the voltage on the BL with the reference voltage.

In some embodiments, polarity switching is not necessary assisted via the alternating current signal each time when data is read from the ferroelectric memory cell. For a voltage time sequence that is not written via the alternating current signal, refer to FIG. 6D. Details are not described herein again.

In Embodiment 2, polarization of the ferroelectric thin film is disturbed via the alternating current signal, to assist in polarization switching of the ferroelectric thin film, so that an operating voltage required for ferroelectric switching of the ferroelectric thin film can be reduced, damage caused by an electric field to the ferroelectric thin film is reduced, thereby improving endurance of a ferroelectric device.

### Embodiment 3

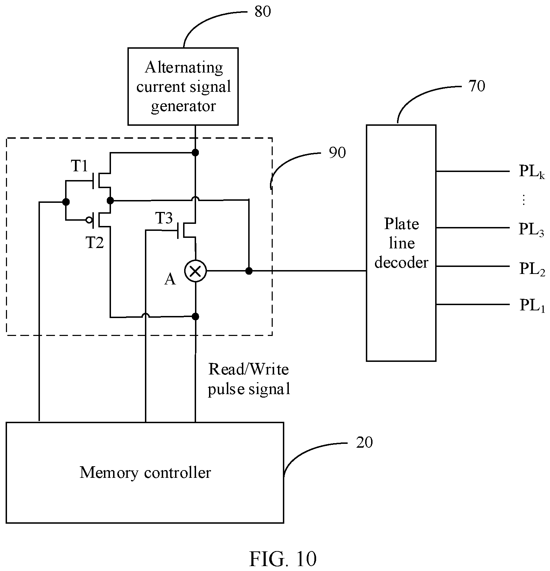

FIG. 10 is a schematic of a circuit of another ferroelectric memory according to an embodiment of this application. The ferroelectric memory may integrate the signal control units shown in Embodiment 1 and Embodiment 2, and the signal control units shown in Embodiment 1 and Embodiment 2 each are connected in parallel between the memory controller 20 and the alternating current signal generator 80. For specific implementation, refer to related descriptions in Embodiment 1 and Embodiment 2. Details are not described herein again.

In some embodiments, the ferroelectric memory shown in FIG. 10 may not include a second switching transistor T2.

It should be understood that the ferroelectric memory cell of the 1T1C structure in the foregoing Embodiment 1 to Embodiment 3 may be replaced with a ferroelectric memory cell of a 2T2C structure, or may be replaced with a ferroelectric memory cell of a 1T2C structure. Because the ferroelectric memory cell of the 1T2C structure is coupled to two plate lines: PL₁ and PL₂, as shown in FIG. 1C, in a read/write interval, the plate line decoder may first select to input the alternating current signal to PL₁, and then select to input the alternating current signal to PL₂.

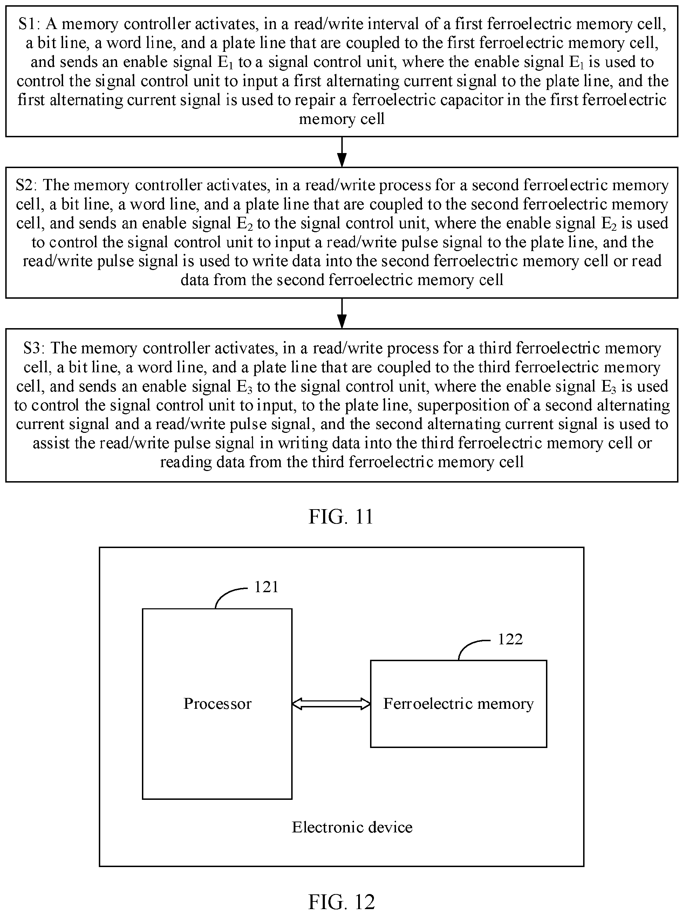

With reference to the ferroelectric memories described in Embodiment 1 to Embodiment 3, the following describes a method for increasing endurance of a ferroelectric memory provided in an embodiment of this application. As shown in FIG. 11, the method may include but is not limited to some or all of the following steps.

S1: A memory controller activates, in a read/write interval of a first ferroelectric memory cell, a bit line, a word line, and a plate line that are coupled to the first ferroelectric memory cell, and sends an enable signal E₁ to a signal control unit, where the enable signal E₁ is used to control the signal control unit to input a first alternating current signal to the plate line, and the first alternating current signal is used to repair a ferroelectric capacitor in the first ferroelectric memory cell.

The first alternating current signal may be the alternating current signal described in Embodiment 1. For specific implementation of S1, refer to the foregoing Embodiment 1. Details are not described herein again.

S2: The memory controller activates, in a read/write process for a second ferroelectric memory cell, a bit line, a word line, and a plate line that are coupled to the second ferroelectric memory cell, and sends an enable signal E₂ to the signal control unit, where the enable signal E₂ is used to control the signal control unit to input a read/write pulse signal to the plate line, and the read/write pulse signal is used to write data into the second ferroelectric memory cell or read data from the second ferroelectric memory cell.

For specific implementation of S2, refer to the foregoing Embodiment 1. Details are not described herein again.

S3: The memory controller activates, in a read/write process for a third ferroelectric memory cell, a bit line, a word line, and a plate line that are coupled to the third ferroelectric memory cell, and sends an enable signal E₃ to the signal control unit, where the enable signal E₃ is used to control the signal control unit to input, to the plate line, superimposition of a second alternating current signal and a read/write pulse signal, and the second alternating current signal is used to assist the read/write pulse signal in writing data into the third ferroelectric memory cell or reading data from the third ferroelectric memory cell.

The second alternating current signal may be the alternating current signal described in Embodiment 2. For specific implementation of S3, refer to the foregoing Embodiment 2. Details are not described herein again.

For example, when a write request for the ferroelectric memory cell is received, that is, in a writing process, the read/write pulse signal is used to write data indicated by a read request into the ferroelectric memory cell.

For another example, when a read request for the ferroelectric memory cell is received, that is, in a read process, the read/write pulse signal is used to read data and write, after the data is read, the data read by the ferroelectric memory cell, that is, data originally stored by the ferroelectric memory cell, into the ferroelectric memory cell.

It should be noted that two or three of the first ferroelectric memory cell, the second ferroelectric memory cell, and the third ferroelectric memory cell may be a same ferroelectric memory cell, or may be different ferroelectric memory cells. The foregoing steps may not be performed in sequence.

An embodiment of this application further provides a chip. The chip may include any one of the ferroelectric memories described in the foregoing Embodiments 1 to 3. Optionally, the chip may further integrate another functional unit, for example, a processor.

An embodiment of this application further provides an electronic device. The electronic device includes a device of any one of the ferroelectric memories described in Embodiments 1 to 3, and may be a mobile phone, a tablet computer, a notebook computer, an ultra-mobile personal computer (ultra-mobile personal computer, UMPC), a netbook, a personal digital assistant (personal digital assistant, PDA), an on board unit (On board Unit, OBU), a wearable device (for example, a watch, a band, or a smart helmet), a smart home device (such as a rice cooker, a speaker, or a home manager device), or a terminal or user equipment such as an augmented reality (augmented reality, AR)/virtual reality (virtual reality, VR) device; may be a server, a cloud, a base station, or the like; or may be a storage device such as a hard disk, a USB flash drive, an SD card, a mini-SD card, a TF card, an MMC card, or a SIM card.

As shown in FIG. 12, an electronic device may include a processor 121 and a ferroelectric memory 122. The processor 121 may be coupled to 122 through a bus. It may be understood that the ferroelectric memory 122 is a non-volatile memory, and may be a hard disk.

In addition, the term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

Terms used in embodiments of this application are merely for the purpose of describing specific embodiments, but are not intended to limit this application. As used in the specification and the appended claims of this application, the singular expressions "a", "one", "said", "the foregoing", "the", and "this" are intended to include also the plural expression, unless the context expressly indicates the contrary. It should be further understood that the term "and/or" as used in this application refers to and includes any or all possible combinations of one or more of the listed items.

According to the context, the term "when" used in the foregoing embodiments may be interpreted as a meaning of "if", "after", "in response to determining", or "in response to detecting". Similarly, according to the context, the phrase "when it is determined that..." or "if (a stated condition or event) is detected" may be interpreted as a meaning of "if it is determined that...", "in response to determining...", "when (a stated condition or event) is detected", or "in response to detecting (a stated condition or event)".

All or some of the foregoing embodiments may be implemented by using software, hardware, firmware, or any combination thereof. When software is used to implement embodiments, all or some of embodiments may be implemented in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive), or the like.

A person of ordinary skill in the art may understand that all or some of the processes of the methods in embodiments may be implemented by a computer program instructing relevant hardware. The program may be stored in a computer-readable storage medium. When the program runs, the processes of the methods in embodiments are performed. The foregoing storage medium includes any medium that can store program code, such as a ROM, a random access memory RAM, a magnetic disk, or an optical disc.

## Claims

1. A control apparatus of a ferroelectric memory, comprising a signal control unit, wherein the signal control unit is coupled to a memory controller, an alternating current signal generator, and a plate line coupled to a ferroelectric memory cell; the memory controller is configured to implement read/write control on the ferroelectric memory cell; the alternating current signal generator is configured to generate a first alternating current signal; and the ferroelectric memory cell comprises a ferroelectric capacitor, and the plate line is connected to one end of the ferroelectric capacitor; and
the signal control unit is configured to switch a signal input to the plate line to the first alternating current signal or a read/write pulse signal output by the memory controller, wherein the read/write pulse signal is used to write data into the ferroelectric memory cell or read data from the ferroelectric memory cell.

2. The control apparatus according to claim 1, wherein the control apparatus further comprises the memory controller, the memory controller is further configured to send a first enable signal to the signal control unit in a read/write interval of the ferroelectric memory cell, and the first enable signal is used to control the signal control unit to input the first alternating current signal to the plate line.

3. The control apparatus according to claim 2, wherein the memory controller is further configured to send a second enable signal to the signal control unit in a read/write process of the ferroelectric memory cell, and the second enable signal is used to control the signal control unit to input the read/write pulse signal to the plate line.

4. The control apparatus according to claim 3, wherein the signal control unit comprises a first switching transistor and a second switching transistor that are connected in series; a first end of the first switching transistor is coupled to the alternating current signal generator, and is configured to receive the first alternating current signal; a second end of the first switching transistor is coupled to a first end of the second switching transistor; a second end of the second switching transistor is coupled to the memory controller, and is configured to receive the read/write pulse signal; the first enable signal is used to control the first switching transistor to be turned on and the second switching transistor to be turned off; and the second enable signal is used to control the first switching transistor to be turned off and the second switching transistor to be turned on.

5. The control apparatus according to claim 4, wherein the first switching transistor is a P-type transistor, and the second switching transistor is an N-type transistor; or the first switching transistor is an N-type transistor, and the second switching transistor is a P-type transistor.

6. The control apparatus according to claim 4, wherein the first enable signal comprises a first signal and a second signal; in the read/write interval of the ferroelectric memory cell, the ferroelectric memory is further configured to send the first signal to the first switching transistor and send the second signal to the second switching transistor; the first signal is used to turn on the first switching transistor; and the second signal is used to turn off the second switching transistor.

7. The control apparatus according to claim 4, wherein the second enable signal comprises a third signal and a fourth signal; in the read/write process of the ferroelectric memory cell, the ferroelectric memory is further configured to send the third signal to the first switching transistor and send the fourth signal to the second switching transistor; the third signal is used to turn off the first switching transistor; and the fourth signal is used to turn on the second switching transistor.

8. The control apparatus according to claim 1, wherein the alternating current signal generator is configured to generate a second alternating current signal; and the signal control unit is further configured to superimpose the second alternating current signal and the read/write pulse signal, and input a superimposed signal to the plate line.

9. The control apparatus according to claim 8, wherein the memory controller is further configured to send a third enable signal to the signal control unit in a read/write process of the ferroelectric memory cell, and the third enable signal is used to control the signal control unit to input the superimposed signal to the plate line.

10. The control apparatus according to claim 8 or 9, wherein an amplitude of the second alternating current signal is less than 1/2 of an amplitude of the read/write pulse signal, and a frequency of the second alternating current signal is greater than a frequency of the read/write pulse signal.

11. The control apparatus according to any one of claims 8 to 10, wherein the signal control unit further comprises a third switching transistor and a multiplier; a first end of the third switching transistor is coupled to the alternating current signal generator, and is configured to receive the second alternating current signal; a second end of the third switching transistor is coupled to a first input end of the multiplier; a second input end of the multiplier is coupled to the memory controller, and is configured to receive the read/write pulse signal; an output end of the multiplier is coupled to the plate line; and the first enable signal is used to control, in the read/write process of the ferroelectric memory cell, the third switching transistor to be turned on.

12. A control apparatus of a ferroelectric memory, comprising: a signal control unit, wherein the signal control unit is coupled to a memory controller, an alternating current signal generator, and a plate line coupled to a ferroelectric memory cell; the memory controller is configured to implement read/write control on the ferroelectric memory cell; the alternating current signal generator is configured to generate an alternating current signal; and the ferroelectric memory cell comprises a ferroelectric capacitor, and the plate line is connected to one end of the ferroelectric capacitor; and
the signal control unit is configured to superimpose the alternating current signal and a read/write pulse signal output by the memory controller, and input a superimposed signal to the plate line, wherein the read/write pulse signal is used to write data into the ferroelectric memory cell or read data from the ferroelectric memory cell.

13. The control apparatus according to claim 12, wherein the control apparatus further comprises the memory controller, the memory controller is configured to send a first enable signal to the signal control unit in a read/write process of the ferroelectric memory cell, and the first enable signal is used to control the signal control unit to input superimposition of the alternating current signal and the read/write pulse signal to the plate line.

14. The control apparatus according to claim 12 or 13, wherein an amplitude of the alternating current signal is less than an amplitude of the read/write pulse signal, and a frequency of the alternating current signal is greater than a frequency of the read/write pulse signal.

15. The control apparatus according to any one of claims 12 to 14, wherein the signal control unit comprises a switching transistor and a multiplier; a first end of the switching transistor is coupled to the alternating current signal generator, and is configured to receive the alternating current signal; a second end of the switching transistor is coupled to a first input end of the multiplier; a second input end of the multiplier is coupled to the memory controller, and is configured to receive the read/write pulse signal; an output end of the multiplier is coupled to the plate line; and the first enable signal is used to control, in the read/write process of the ferroelectric memory cell, the switching transistor to be turned on.

16. A ferroelectric memory, comprising a memory array, a signal control unit, and a memory controller, wherein the memory array comprises a plurality of ferroelectric memory cells, and all ferroelectric memory cells in one memory array are coupled to a same plate line; the signal control unit is coupled to the memory controller, an alternating current signal generator, and a plate line coupled to the memory array; the memory controller is configured to implement read/write control on each ferroelectric memory cell; the alternating current signal generator is configured to generate a first alternating current signal; and each ferroelectric memory cell comprises a ferroelectric capacitor, and the plate line is connected to one end of each ferroelectric capacitor; and
the signal control unit is configured to switch a signal input to the plate line to the first alternating current signal or a read/write pulse signal output by the memory controller, wherein the read/write pulse signal is used to write data into the ferroelectric memory cell or read data from the ferroelectric memory cell.

17. The ferroelectric memory according to claim 16, wherein the memory controller is further configured to send a first enable signal to the signal control unit in a read/write interval of the ferroelectric memory cell, and the first enable signal is used to control the signal control unit to input the first alternating current signal to the plate line.

18. The ferroelectric memory according to claim 17, wherein the memory controller is further configured to send a second enable signal to the signal control unit in a read/write process of the ferroelectric memory cell, and the second enable signal is used to control the signal control unit to input the read/write pulse signal to the plate line.

19. The ferroelectric memory according to claim 18, wherein the signal control unit comprises a first switching transistor and a second switching transistor that are connected in series; a first end of the first switching transistor is coupled to the alternating current signal generator, and is configured to receive the first alternating current signal; a second end of the first switching transistor is coupled to a first end of the second switching transistor; a second end of the second switching transistor is coupled to the memory controller, and is configured to receive the read/write pulse signal; the first enable signal is used to control the first switching transistor to be turned on and the second switching transistor to be turned off; and the second enable signal is used to control the first switching transistor to be turned off and the second switching transistor to be turned on.

20. The ferroelectric memory according to claim 19, wherein the first switching transistor is a P-type transistor, and the second switching transistor is an N-type transistor; or the first switching transistor is an N-type transistor, and the second switching transistor is a P-type transistor.

21. The ferroelectric memory according to claim 19, wherein the first enable signal comprises a first signal and a second signal; in the read/write interval of the ferroelectric memory cell, the ferroelectric memory is further configured to send the first signal to the first switching transistor and send the second signal to the second switching transistor; the first signal is used to turn on the first switching transistor; and the second signal is used to turn off the second switching transistor.

22. The ferroelectric memory according to claim 19, wherein the second enable signal comprises a third signal and a fourth signal; in the read/write process of the ferroelectric memory cell, the ferroelectric memory is further configured to send the third signal to the first switching transistor and send the fourth signal to the second switching transistor; the third signal is used to turn off the first switching transistor; and the fourth signal is used to turn on the second switching transistor.

23. The ferroelectric memory according to claim 16, wherein the alternating current signal generator is further configured to generate a second alternating current signal; and the signal control unit is further configured to superimpose the second alternating current signal and the read/write pulse signal, and input a superimposed signal to the plate line.

24. The ferroelectric memory according to claim 23, wherein the memory controller is further configured to send a third enable signal to the signal control unit in a read/write process of the ferroelectric memory cell, and the third enable signal is used to control the signal control unit to input the second alternating current signal and the superimposed signal to the plate line.

25. The ferroelectric memory according to claim 23 or 24, wherein an amplitude of the second alternating current signal is less than 1/2 of an amplitude of the read/write pulse signal, and a frequency of the second alternating current signal is greater than a frequency of the read/write pulse signal.

26. The ferroelectric memory according to any one of claims 23 to 25, wherein the signal control unit further comprises a third switching transistor and a multiplier; a first end of the third switching transistor is coupled to the alternating current signal generator, and is configured to receive the second alternating current signal; a second end of the third switching transistor is coupled to a first input end of the multiplier; a second input end of the multiplier is coupled to the memory controller, and is configured to receive the read/write pulse signal; an output end of the multiplier is coupled to the plate line; and the first enable signal is used to control, in the read/write process of the ferroelectric memory cell, the third switching transistor to be turned on.

27. A ferroelectric memory, comprising a memory array, a signal control unit, and a memory controller, wherein the memory array comprises a plurality of ferroelectric memory cells, and all ferroelectric memory cells in one memory array are coupled to a same plate line; the signal control unit is coupled to the memory controller, an alternating current signal generator, and a plate line coupled to the memory array; the memory controller is configured to implement read/write control on each ferroelectric memory cell; the alternating current signal generator is configured to generate an alternating current signal; and each ferroelectric memory cell comprises a ferroelectric capacitor, and the plate line is connected to one end of each ferroelectric capacitor; and
the signal control unit is configured to superimpose the alternating current signal and a read/write pulse signal output by the memory controller, and input a superimposed signal to the plate line, wherein the read/write pulse signal is used to write data into the ferroelectric memory cell or read data from the ferroelectric memory cell.

28. The ferroelectric memory according to claim 27, wherein the control apparatus further comprises the memory controller, the memory controller is configured to send a first enable signal to the signal control unit in a read/write process of the ferroelectric memory cell, and the first enable signal is used to control the signal control unit to input the superimposed signal to the plate line.

29. The ferroelectric memory according to claim 27 or 28, wherein an amplitude of the alternating current signal is less than an amplitude of the read/write pulse signal, and a frequency of the alternating current signal is greater than a frequency of the read/write pulse signal.

30. The ferroelectric memory according to any one of claims 27 to 29, wherein the signal control unit comprises a switching transistor and a multiplier; a first end of the switching transistor is coupled to the alternating current signal generator, and is configured to receive the alternating current signal; a second end of the switching transistor is coupled to a first input end of the multiplier; a second input end of the multiplier is coupled to the memory controller, and is configured to receive the read/write pulse signal; an output end of the multiplier is coupled to the plate line; and the first enable signal is used to control, in the read/write process of the ferroelectric memory cell, the switching transistor to be turned on.

31. A method for increasing endurance of a ferroelectric memory, wherein the ferroelectric memory comprises a memory array, a signal control unit, and a memory controller; the memory array comprises a plurality of ferroelectric memory cells, and all ferroelectric memory cells in one memory array are coupled to a same plate line; the signal control unit is coupled to the memory controller, an alternating current signal generator, and a plate line coupled to the memory array; the memory controller is configured to implement read/write control on each ferroelectric memory cell; the alternating current signal generator is configured to generate an alternating current signal; each ferroelectric memory cell comprises a ferroelectric capacitor, and the plate line is connected to one end of each ferroelectric capacitor; and the signal control unit is configured to switch a signal input to the plate line to the alternating current signal or a read/write pulse signal output by the memory controller, wherein the read/write pulse signal is used to write data into the ferroelectric memory cell or read data from the ferroelectric memory cell; and
the method comprises:
switching, by the memory controller, the signal input to the plate line to the alternating current signal through the signal control unit in a read/write interval of the ferroelectric memory cell.

32. The method according to claim 31, wherein the switching the signal input to the plate line to the alternating current signal through the signal control unit comprises: sending, by the memory controller, a first enable signal to the signal control unit, wherein the first enable signal is used to control the signal control unit to input the alternating current signal to the plate line.

33. The method according to claim 31 or 32, wherein the method further comprises:
sending, by the memory controller, a second enable signal to the signal control unit in a read/write process of the ferroelectric memory cell, wherein the second enable signal is used to control the signal control unit to input the read/write pulse signal to the plate line.

34. A method for increasing endurance of a ferroelectric memory, wherein the ferroelectric memory comprises a memory array, a signal control unit, and a memory controller; the memory array comprises a plurality of ferroelectric memory cells, and all ferroelectric memory cells in one memory array are coupled to a same plate line; the signal control unit is coupled to the memory controller, an alternating current signal generator, and a plate line coupled to the memory array; the memory controller is configured to implement read/write control on each ferroelectric memory cell; the alternating current signal generator is configured to generate an alternating current signal; each ferroelectric memory cell comprises a ferroelectric capacitor, and the plate line is connected to one end of each ferroelectric capacitor; and the signal control unit is configured to superimpose the alternating current signal and a read/write pulse signal output by the memory controller, and input a superimposed signal to the plate line, wherein the read/write pulse signal is used to write data into the ferroelectric memory cell or read data from the ferroelectric memory cell; and
the method comprises:
superimposing, by the memory controller through the signal control unit in a read/write process of the ferroelectric memory cell, the alternating current signal and the read/write pulse signal output by the memory controller, and inputting a superimposed signal to the plate line.

35. The method according to claim 34, wherein the method further comprises: sending, by the memory controller, a first enable signal to the signal control unit, wherein the first enable signal is used to control the signal control unit to input the superimposed signal to the plate line.

36. An electronic device, comprising a mainboard, a processor coupled to the mainboard, and the ferroelectric memory according to any one of claims 16 to 30.
